# EUROPEAN PATENT APPLICATION

(11) **EP 4 538 759 A1**
(43) Date of publication of application: **16.04.2025**
(21) Application number: 24205481.5
(22) Date of filing: 09.10.2024
(51) Int. Cl.: G02B 6/12, G02B 6/122, G02B 6/125, G02B 6/14, H01S 5/02

(54) **LASER WITH EDGE COUPLER DISPLACED FROM SUBSTRATE**

(30) Priority: 13.10.2023 US 202318379848
(71) Applicant: OpenLight Photonics, Inc., Goleta, CA 93117 (US)
(72) Inventor: BARIK, Sabyasachi, Santa Barbara 93105 (US); LUAN, Enxiao, Vancouver V6R2J5 (CA); BAUTERS, Jared, Santa Barbara 93105 (US)
(74) Representative: D Young & Co LLP

(57) **Abstract**

A device includes a semiconductor substrate, a light source displaced from the semiconductor substrate by a first displacement, a first dielectric waveguide displaced from the semiconductor substrate by a second displacement, and a second dielectric waveguide displaced from the semiconductor substrate by a third displacement. The second displacement is greater than the first displacement. The first dielectric waveguide overlaps at least a portion of the light source such that light is adiabatically coupled from the light source into the first dielectric waveguide. The third displacement is greater than the second displacement. The second dielectric waveguide overlaps at least a portion of the first dielectric waveguide such that light is coupled from the first dielectric waveguide into the second dielectric waveguide. The second dielectric waveguide includes an edge coupler configured to couple light out of the second dielectric waveguide.

## Description

### TECHNICAL FIELD

The present disclosure generally relates to optical devices and more particularly to edge couplings for optical devices.

### BACKGROUND

Many photonic applications require repeatable and low loss optical coupling with optical sources, such as lasers configured to generate light, semiconductor optical amplifiers (SOAs) configured to amplify and propagate light, or modulators configured to modulate and propagate light. In many such application, it is beneficial for the optical sources to be manufacturable at high volumes. Accordingly, silicon photonic technologies such as hybrid lasers may be used to achieve low-cost, high-volume manufacture of light sources at wafer scale. However, optical sources formed in silicon tend to face various design limitations regarding the outcoupling of light to a receiving device.

### SUMMARY

Particular aspects are set out in the appended independent claims. Various optional embodiments are set out in the dependent claims.

### BRIEF DESCRIPTION OF THE SEVERAL VIEWS OF THE DRAWINGS

The following description includes discussion of figures having illustrations given by way of example of implementations of embodiments of the disclosure. The drawings should be understood by way of example, and not by way of limitation. As used herein, references to one or more "examples" or "embodiments" are to be understood as describing a particular feature, structure, or characteristic included in at least one implementation of the inventive subject matter, in at least some circumstances. Thus, phrases such as "in one example", "in some examples", "in some embodiments", "in one embodiment" or "in an alternate embodiment" appearing herein describe various embodiments and implementations of the inventive subject matter, and do not necessarily all refer to the same embodiment. However, they are also not necessarily mutually exclusive. To easily identify the discussion of any particular element or act, the most significant digit or digits in a reference number may refer to the figure ("FIG.") number in which that element or act is first introduced.
FIG. 1 illustrates a side cross-sectional view of a device showing displacement of components of the device from a semiconductor substrate, according to some examples.
FIG. 2 illustrates the side cross-sectional view of the device of FIG. 1, showing four regions of adiabatic mode coupling between components of the device, according to some examples.
FIG. 3 illustrates a bottom plan view showing an overlap of the first dielectric waveguide and second dielectric waveguide of the device of FIG. 1, according to some examples.
FIG. 4A illustrates a front cross-sectional view of the device of FIG. 1 through line A-A of FIG. 3, according to some examples.
FIG. 4B illustrates a front cross-sectional view of the device of FIG. 1 through line B-B of FIG. 3, according to some examples.
FIG. 5 illustrates a flowchart showing operations of a method of manufacturing a device, in accordance with some examples.

Descriptions of certain details and implementations follow, including a description of the figures, which may depict some or all of the embodiments described below, as well as discussing other potential embodiments or implementations of the inventive concepts presented herein. An overview of embodiments of the disclosure is provided below, followed by a more detailed description with reference to the drawings.

### DETAILED DESCRIPTION

In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, structures, and techniques are not necessarily shown in detail.

As described above, light sources formed in silicon may face various design limitations relating to outcoupling of light. In SOI (silicon on insulator) photonic platforms with a buried insulator, it can be beneficial to keep the lasers or SOAs close to the semiconductor substrate for the purpose of heat sinking. However, if an edge coupler is used to outcouple the light to the receiving device, it can be beneficial to use an edge coupler having low loss and a large mode field diameter (MFD), and such edge couplers tend to perform better at a greater distance from the semiconductor substrate. The farther the edge coupler is from the substrate, the larger the output field can be, and the less substrate leakage loss the edge coupler will experience.

Existing approaches to SOI photonic platforms with edge couplers tend to neglect the heat sinking issue, leading to thermal limitations, and/or to neglect the edge coupling issue, leading to limitations on optical performance and reduced power efficiency. One such approach is described by Xiang, C., Jin, W., Terra, O. et al. 3D integration enables ultralow-noise isolator-free lasers in silicon photonics. Nature 620, 78-85 (2023). https://doi.org/10.1038/s41586-023-06251-w (hereinafter "Xiang"). The approach described in Xiang uses ultra low loss (ULL) dielectric waveguides having highly delocalized modes, thereby achieving a relatively large mode at the edge coupler. However, Xiang neglects the heat sinking issue, moving the lasers even farther away from the silicon substrate than in previous approaches. The nature of Xiang's ULL waveguide coupling and other components requires very long length scales, which are larger than a typical photonic integrated circuit (PIC) size. Accordingly, the approach described in Xiang results in low output power, and it requires larger PICs (thereby increasing the costs of manufacture) and two bonding steps (further increasing costs). Other approaches exhibit similar limitations.

Accordingly, examples described herein may attempt to address one or more technical problems related to the design and manufacture of silicon photonic light sources such as hybrid silicon lasers and SOAs. In particular, some examples may provide a device in which the laser or SOA is integrated on top of a SOI substrate and located close to the semiconductor substrate to assist in heat sinking, but the edge coupler is located farther from the semiconductor substrate, thereby allowing a relatively low-loss, large-MFD edge coupler to be used. In some examples, the light from the light source is propagated through a first dielectric waveguide (e.g., a relatively thick silicon nitride layer) relatively close to the semiconductor substrate, and then coupled into a second dielectric waveguide (e.g., another, thinner silicon nitride layer) relatively far from the semiconductor substrate, via fast adiabatic coupling, thereby enabling the two dielectric waveguides to be arranged in a relatively compact configuration. The second dielectric waveguide terminates in an edge coupler that expands the optical mode. The edge coupler has a relatively large MFD, which is enabled by its spatial displacement from the semiconductor substrate, thereby lowering edge coupling loss to external optics.

Unlike existing approaches, examples described herein may incorporate multiple passive waveguide layers, which can be manufactured as part of a single platform (e.g., a single chip).

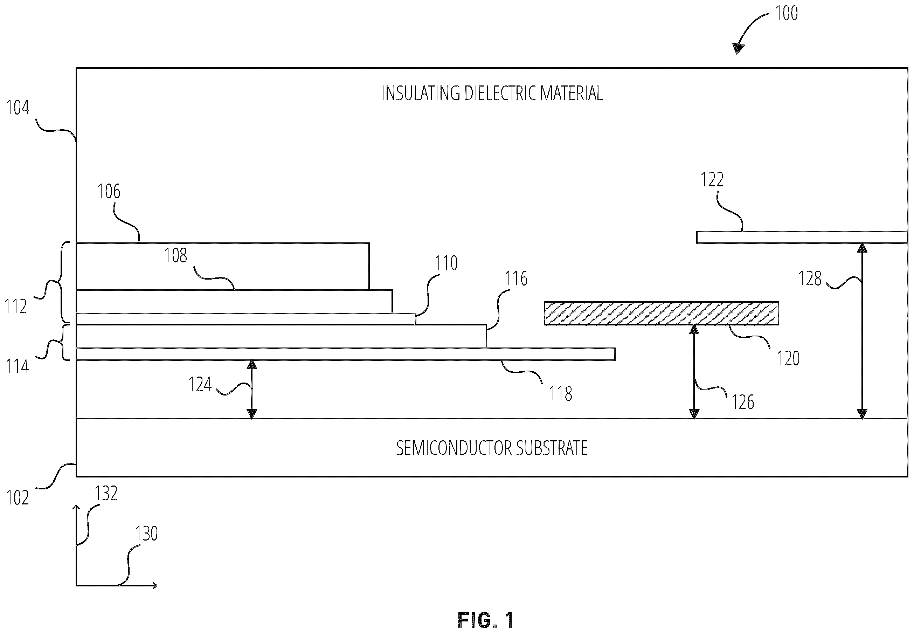

FIG. 1 is a side cross-sectional view of a device 100 showing vertical displacement of components of the device 100 from a semiconductor substrate 102. In some examples, the device 100 is a photonic device (also referred to as a photonic platform) with a buried insulator (not shown in FIG. 1), such as an SOI device.

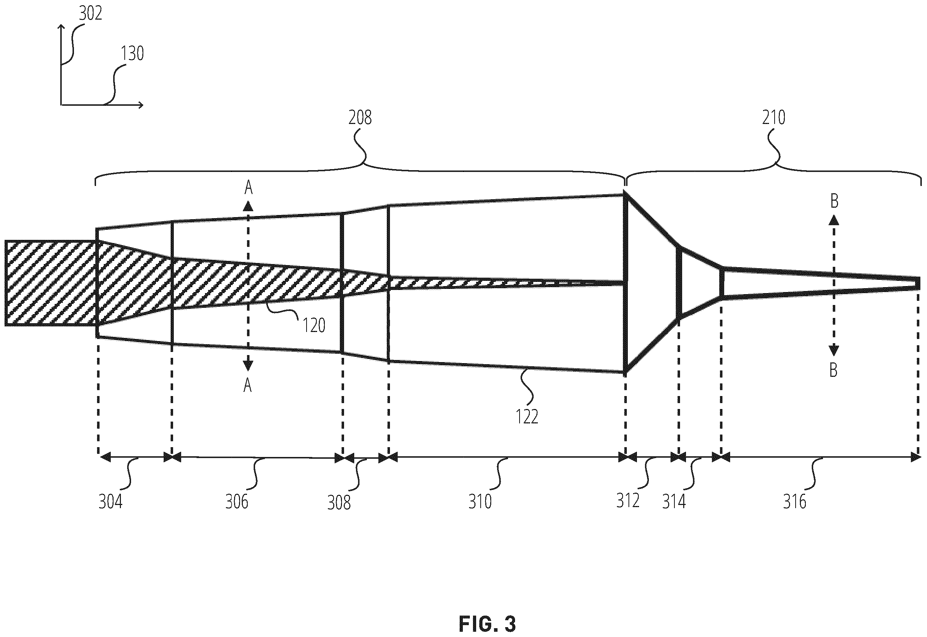

The device 100 may be fabricated as layers stacked along a lamination axis 132 defining the vertical dimension of the drawing. The view of FIG. 1 shows the device 100 extending in a longitudinal direction 130 from left to right. A lateral axis (shown in the bottom view of FIG. 3 below) extends into and out of the plane of the drawing of FIG. 1. It will be appreciated that the drawings of the device 100 are not to scale, nor do they depict the entire device. In some examples, the lateral and/or longitudinal dimensions of the device 100 and its various components may be much greater than the height of the components along the lamination axis 132, possibly by one or more orders of magnitude. For example, the height of the entire device 100 along the lamination axis 132 may be less than 10 micrometers (µm), whereas the length of the illustrated portion of the device 100 extending in the longitudinal direction 130 may be several hundred µm, or even several millimeters (mm). The illustrated views are simplified for the sake of clarity.

The device 100 includes a semiconductor laser 112 manufactured relatively close to the semiconductor substrate 102 (e.g., silicon) to improve thermal performance. The laser 112 includes, from top to bottom, a ridge or layer of p-type material 106 above an active region 108 (e.g., a multiple quantum well emissive region of the laser), with a layer of n-type material 110 underneath. Under the n-type material 110 is a silicon waveguide 114 having an upper portion 116 and a lower portion 118. In the illustrated example, the lower portion 118 extends farther in the longitudinal direction 130 than the upper portion 116. In examples described herein using lasers or other light sources having a waveguide, the lowest surface of the light source (such as a bottom surface of the waveguide) defines the first displacement 124.

The bottom of the lower portion 118 of the silicon waveguide 114 is displaced from the semiconductor substrate 102 by a first displacement 124, which is filled with one or more layers of an insulating dielectric material 104, such as an oxide. In some examples, the first displacement 124 is a distance of less than 1.5 µm, such as 1270 nanometers (nm).

A relatively thick dielectric waveguide (such as a silicon nitride waveguide), shown as first dielectric waveguide 120, is formed slightly above the laser waveguide layer (e.g., above the upper surface of the lower portion 118 of the silicon waveguide 114), such that the bottom surface of the first dielectric waveguide 120 is displaced from the semiconductor substrate by a second displacement 126. In some examples, the second displacement 126 is such that the first dielectric waveguide 120 is located in the longitudinal direction 130 from a portion of the laser 112, such as the active region 108 of the laser 112. For example, the second displacement 126 may be approximately 1.5 µm, such as 1540 nm. The gap between the lower portion 118 of the silicon waveguide 114 and the first dielectric waveguide 120 may be formed from one or more further layers of the insulating dielectric material 104. Thus, in some examples, the lower surface of the first dielectric waveguide 120 may be at approximately the same distance from the semiconductor substrate 102 as one or more layers of the light source; however, the bottom surface of the light source (in this case, the lower surface of the lower portion 118 of the silicon waveguide 114) is at a first displacement 124 from the semiconductor substrate 102 that is less than the second displacement 126 of the first dielectric waveguide 120.

A further one or more layers of the insulating dielectric material 104 are also deposited above the first dielectric waveguide 120. In some examples, these additional layers of insulating dielectric material 104 define a gap of approximately 1 µm or more above the first dielectric waveguide 120. A second, thinner dielectric waveguide (which may also be a silicon nitride waveguide), shown as second dielectric waveguide 122, is formed above this gap and adiabatically coupled to the first dielectric waveguide 120. The second dielectric waveguide 122 may therefore be more than 1 µm farther away from the semiconductor substrate 102 than the first dielectric waveguide 120, with the bottom surface of the second dielectric waveguide 122 being displaced from the semiconductor substrate 102 by a third displacement 128. In some examples, the third displacement 128 is at least 3 µm, such as 3180 nm. The relatively large third displacement 128 may allow for incorporation into the second dielectric waveguide 122 an edge coupler with a large MFD, having lower loss and more repeatable coupling than would be possible if the second dielectric waveguide 122 were located closer to the semiconductor substrate 102.

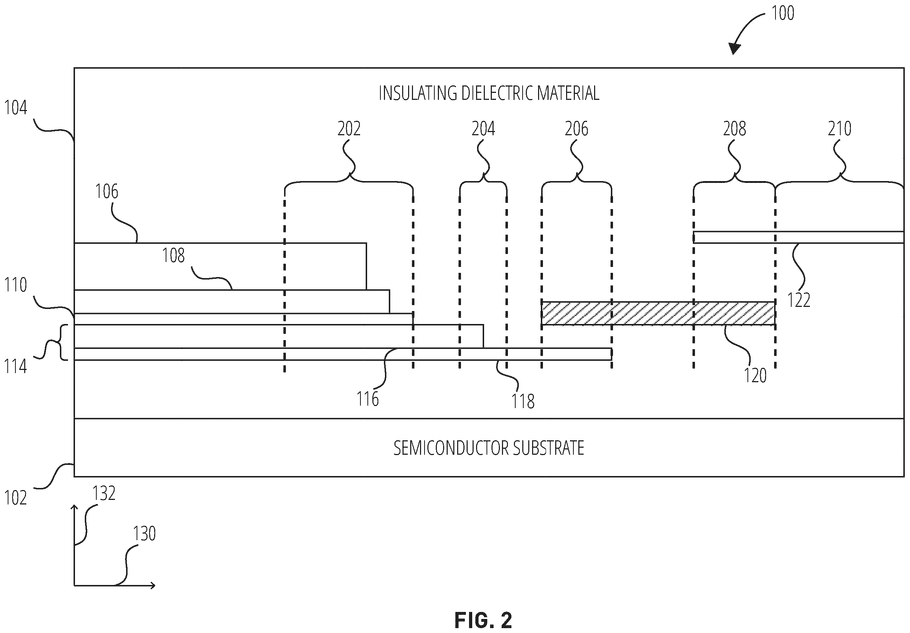

FIG. 2 shows the same side cross-sectional view of the device 100 as in FIG. 1. However, FIG. 2 shows four regions of adiabatic mode coupling between components of the device 100, as well as an edge coupler 210 defined by a portion of the second dielectric waveguide 122.

From left to right in the longitudinal direction 130, four adiabatic mode couplers (AMCs) are shown. In a first AMC 202, light generated by the active region 108 of the laser 112 is adiabatically coupled into the silicon waveguide 114. In a second AMC 204, the light propagating through the silicon waveguide 114 is adiabatically coupled downward from the upper portion 116 into the lower portion 118. In a third AMC 206, the light propagating within the lower portion 118 is adiabatically coupled upward into the first dielectric waveguide 120. In a fourth AMC 208, the light propagating within the first dielectric waveguide 120 is adiabatically coupled upward into the second dielectric waveguide 122.

The third AMC 206 may be regarded as an overlap, with respect to the lamination axis 132, of the lower portion 118 and the first dielectric waveguide 120. In some examples, the third AMC 206 extends in the longitudinal direction 130 over a length of less than 120 µm.

Similarly, the fourth AMC 208 may be regarded as an overlap, with respect to the lamination axis 132, of the first dielectric waveguide 120 and the second dielectric waveguide 122. The length and nature of this overlap in the longitudinal direction 130 is described below with reference to FIG. 3.

The right portion of the second dielectric waveguide 122 defines an edge coupler 210, as will be described in greater detail below with reference to FIG. 3.

Thus, in some examples, the device 100 includes a semiconductor substrate 102, a light source (e.g., laser 112) displaced from the semiconductor substrate 102 by a first displacement 124 with respect to the lamination axis 132, a first dielectric waveguide 120 displaced from the semiconductor substrate 102 by a second displacement 126 with respect to the lamination axis 132, and a second dielectric waveguide 122 displaced from the semiconductor substrate 102 by a third displacement 128 with respect to the lamination axis 132. The second displacement 126 is greater than the first displacement 124, and the third displacement 128 is greater than the second displacement 126. The first dielectric waveguide 120 overlaps at least a portion of the light source with respect to the lamination axis 132 such that light is adiabatically coupled from the light source into the first dielectric waveguide 120. The second dielectric waveguide 122 overlaps at least a portion of the first dielectric waveguide 120 with respect to the lamination axis 132 such that light is coupled from the first dielectric waveguide 120 into the second dielectric waveguide. The second dielectric waveguide 122 includes an edge coupler 210 configured to couple light out of the second dielectric waveguide 122 in a longitudinal direction 130 perpendicular to the lamination axis 132.

In some examples, the third displacement 128 is at least 1 micrometer greater than the second displacement 126.

In some examples, the third displacement 128 is at least 3 micrometers.

In some examples, the light source includes a hybrid silicon laser 112.

In some examples, the device 100 includes a plurality of layers stacked with respect to the lamination axis.

In some examples, the first displacement 124, second displacement 126, and third displacement 128 each comprise one or more layers of an insulating dielectric material 104.

In some examples, the hybrid silicon laser 112 includes a III-V semiconductor structure (e.g., p-type material 106, active region 108, and n-type material 110), and a silicon waveguide 114 displaced from the semiconductor substrate 102 by the first displacement 124. The first dielectric waveguide 120 overlaps with a portion of the silicon waveguide 114 (e.g., lower portion 118) with respect to the lamination axis 132.

In some examples, the first dielectric waveguide 120 and a portion of the III-V semiconductor structure (e.g., at least active region 108) are equally displaced from the semiconductor substrate 102 with respect to the lamination axis 132.

FIG. 3 is a bottom plan view showing the overlap of the first dielectric waveguide 120 and the second dielectric waveguide 122, and showing the geometry of the edge coupler 210. The plane of the bottom view of FIG. 3 is defined by the longitudinal direction 130 and a lateral axis 302; the view is along the lamination axis 132.

It will be appreciated that only the right-most portion of the first dielectric waveguide 120 is shown in FIG. 3. The first dielectric waveguide 120 extends to the left (opposite the longitudinal direction 130) a significant distance, including the portion of the first dielectric waveguide 120 overlapping the silicon waveguide 114 within the third AMC 206.

The overlap of the first dielectric waveguide 120 and second dielectric waveguide 122 defines the fourth AMC 208, as described in reference to FIG. 2 above. Within the fourth AMC 208, the first dielectric waveguide 120 defines a number of segments that taper from wide to narrow in the longitudinal direction 130. In the illustrated example, each segment tapers linearly in the longitudinal direction 130, with the dimensions and degree of taper of each segment being defined by constraints on diameters of the mode of the light being propagated by the first dielectric waveguide 120. In the illustrated example, these segments have lengths L_{T0} 304, L_{TE} 306, L_{T1} 308, and L_{TM} 310 extending in the longitudinal direction 130.

Also within the fourth AMC 208, the second dielectric waveguide 122 defines a number of segments overlapping the segments of the first dielectric waveguide 120. In the illustrated example, there are four segments of the second dielectric waveguide 122 overlapping the four segments of the first dielectric waveguide 120 along lengths L_{T0} 304, L_{TE} 306, L_{T1} 308, and L_{TM} 310. In contrast to the segments of the first dielectric waveguide 120, which narrow in the longitudinal direction 130, the segments of the second dielectric waveguide 122 widen in the longitudinal direction 130, to increase the degree to which the light propagating within the first dielectric waveguide 120 outcouples to the second dielectric waveguide 122 within the fourth AMC 208.

In some examples, the edge coupler 210 acts as a spot size converter (SSC). Within the length of the edge coupler 210, the second dielectric waveguide 122 defines a number of segments that narrow in the longitudinal direction 130, thereby squeezing out the mode of the light propagating within the second dielectric waveguide 122. In the illustrated example, these segments of the edge coupler 210 have lengths L₃ 312, L₂ 314, and Li 316. As with the narrowing segments of the first dielectric waveguide 120 within the fourth AMC 208, the dimensions of the narrowing segments of the edge coupler 210 are defined by constraints on the diameters of the mode of the light being propagated through the edge coupler 210.

Thus, in some examples, the edge coupler 210 of the second dielectric waveguide 122 includes a plurality of segments, each segment decreasing in width as it extends in the longitudinal direction 130.

In some examples, the first dielectric waveguide 120 includes a plurality of segments, each segment increasing in width as it extends in the longitudinal direction 130.

In some examples, the first dielectric waveguide 120 and the second dielectric waveguide 122 each comprise silicon nitride.

Various examples may use different dimensions for the various segments, depending on design considerations such as the intended application of the device 100.

In a first example, the device 100 is coupled to a lens at the right (longitudinal) tip of the edge coupler 210, and the lens propagates the light received from the edge coupler 210 into free space. Such a configuration may be used in applications such as Light Detection and Ranging (LIDAR) arrays, in which the light is coupled through the lens into air, and the beam of light propagates through the air, hits a target, and returns at a slightly displaced angle from the outgoing beam. In such applications, having light outcoupled from the edge coupler 210 with a large mode size may provide improved mode overlap and lower loss for the returned optical beam.

The first example device 100 described above may be designed to achieve an MFD greater than 7 µm with respect to vertical and horizontal axes in both the L_{TE} 306 and L_{TM} 310 sections, as well as circularity greater than 85%. The first example device 100 may have a tip width (of the right-most tip of the edge coupler 210) of 0.25 µm, and a length Li 316 of 90 µm. It may be configured to achieve, within the length of L_{TE} 306: a horizontal (along lateral axis 302) MFD(y) of 7.9 µm, a vertical (along lamination axis 132) MFD(z) of 7.1 µm, circularity (MFD(z)/MFD(y)) of 0.9, and free space coupling loss of 0.8 dB. It may be configured to achieve, within the length of L_{TM} 310: a horizontal MFD(y) of 8.6 µm, a vertical MFD(z) of 7.6 µm, circularity (MFD(z)/MFD(y)) of 0.88, and free space coupling loss of 1 dB. If an optical fiber were to be coupled to the edge coupler, the maximum fiber insertion loss of the L_{TE} 306 section would be 1.75 dB, whereas the maximum fiber insertion loss of the L_{TM} 310 section would be 2 dB.

Thus, in some examples, the device 100 further includes a lens optically coupled to the edge coupler 210 in the longitudinal direction 130 to receive the light outcoupled by the edge coupler 210.

In a second example, the device 100 is coupled to a single mode optical fiber at the tip of the edge coupler 210. Low optical coupling losses may be achieved due to improved mode-overlap between the output of the edge coupler 210 and the fiber mode size. Thus, the larger size of the MFD provided at the tip of the edge coupler 210 may provide wider alignment tolerances for the optical fiber, which may also result in lower coupling losses. A lens can be optionally added between the edge coupler and fiber to further reduce the optical losses, but it is beneficial to avoid this lens to reduce cost. The optical losses achieved without the lens are low enough to be sufficient in most applications.

The second example device 100 described above may be designed to achieve optimal fiber coupling, low insertion loss, and low polarization-dependent loss (PDL). The second example device 100 may have a tip width (of the right-most tip of the edge coupler 210) of 0.4 µm, and a length Li 316 of 60 µm. It may be configured to achieve, within the length of L_{TE} 306: a horizontal MFD(y) of 6.8 µm, a vertical MFD(z) of 4.7 µm, circularity (MFD(z)/MFD(y)) of 0.7, and free space coupling loss of 0.5 dB. It may be configured to achieve, within the length of L_{TM} 310: a horizontal MFD(y) of 6.8 µm, a vertical MFD(z) of 6.3 µm, circularity (MFD(z)/MFD(y)) of 0.95, and free space coupling loss of 0.6 dB. The maximum fiber insertion loss of the L_{TE} 306 section is 1.7 dB, whereas the maximum fiber insertion loss of the L_{TM} 310 section is 1.6 dB.

Thus, in some examples, the device 100 further includes an optical fiber optically coupled to the lens to receive the light from the lens, or an optical fiber optically coupled to the edge coupler to receive the light from the edge coupler.

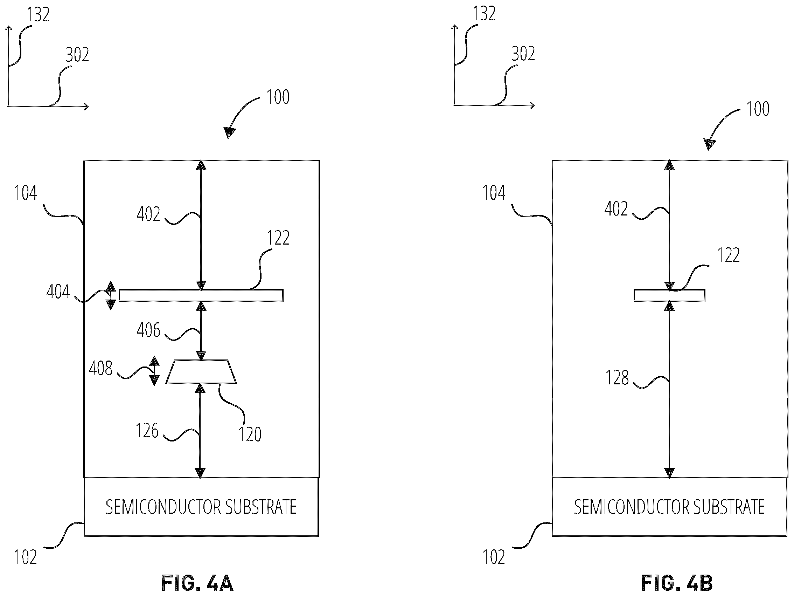

FIG. 4A is a front cross-sectional view of the device 100 through line A-A of FIG. 3, showing a frontal cross-section of the shapes and positions of the first dielectric waveguide 120 and the second dielectric waveguide 122 within the fourth AMC 208 (within the segment of length L_{TE} 306). The plane of the drawing is defined by the lamination axis 132 and the lateral axis 302.

As shown, the first dielectric waveguide 120 is displaced from the semiconductor substrate 102 by insulating dielectric material 104 filling the second displacement 126, e.g., 1540 nm. The first dielectric waveguide 120 is trapezoidal in cross-section in this example, having a wider lateral width at its bottom surface than at its top surface. In this example, the angle of the sides of the first dielectric waveguide 120 to its bottom surface is 84 degrees. The height of the first dielectric waveguide 120 is defined by first thickness 408, e.g., 390 nm.

Above the first dielectric waveguide 120, the insulating dielectric material 104 fills a middle distance 406 between the first dielectric waveguide 120 and second dielectric waveguide 122, e.g., 1250 nm. The second dielectric waveguide 122 is shown as rectangular in cross-section, with a height defined by second thickness 404, e.g., 160 nm. Finally, an upper distance 402 extends upward from the top surface of the second dielectric waveguide 122 to the top of the device 100, filled with further layers of the insulating dielectric material 104, e.g., for a distance of 7875 nm.

FIG. 4B is a further front cross-sectional view of the device 100, this view taken through line B-B of FIG. 3, showing a frontal cross-section of the shape and position of the second dielectric waveguide 122 within the edge coupler 210 close to the tip (within the right-most segment of length Li 316).

In this view, the third displacement 128 is shown to be filled with the insulating dielectric material 104, e.g., to a height of 3180 nm. The other dimensions are as in FIG. 4A.

Thus, in the illustrated example, the insulating dielectric material 104 in which the first dielectric waveguide 120 and second dielectric waveguide 122 are embedded extends a total of 11,215 nm (third displacement 128 of 3180 nm + second thickness 404 of 160 nm + upper distance 402 of 7875 nm).

It will be appreciated that these dimensions are intended solely as illustrative examples, and that various examples may depart from these dimensions to achieve different goals.

Thus, in some examples, the first dielectric waveguide 120 has a first thickness 408 defined with respect to the lamination axis 132, the second dielectric waveguide 122 has a second thickness 404 defined with respect to the lamination axis 132, and the first thickness 408 is thicker than the second thickness 404.

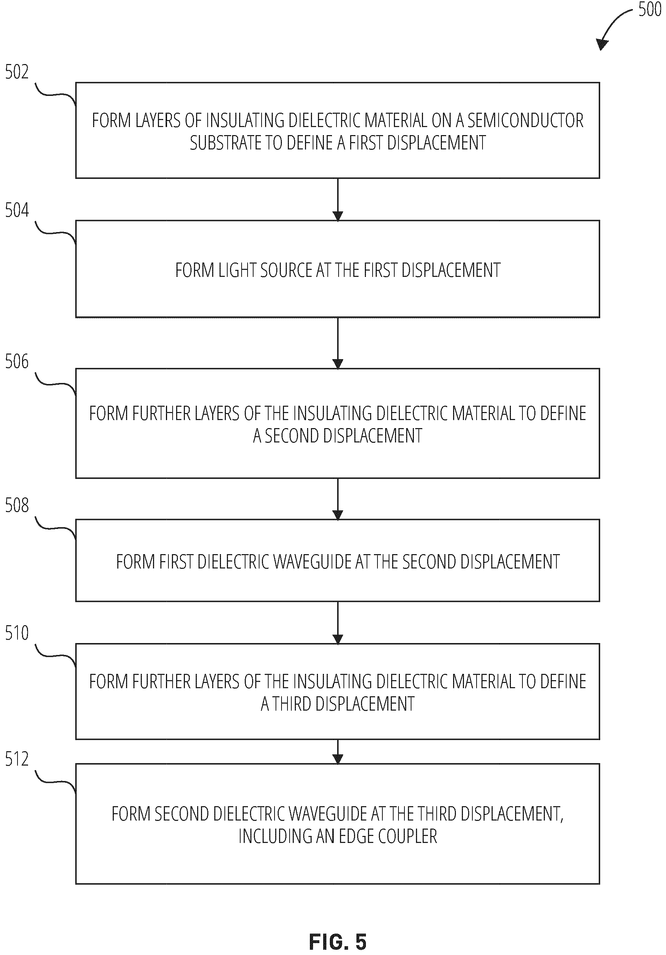

FIG. 5 shows operations of a method 500 of manufacturing a device, such as device 100. Although the example method 500 depicts a particular sequence of operations, the sequence may be altered without departing from the scope of the present disclosure. For example, some of the operations depicted may be performed in parallel or in a different sequence that does not materially affect the function of the method 500. In other examples, different components of an example device or system that implements the method 500 may perform functions at substantially the same time or in a specific sequence.

According to some examples, the method 500 includes forming layers of insulating dielectric material 104 on a semiconductor substrate 102 to define a first displacement 124 at operation 502.

According to some examples, the method 500 includes forming a light source (e.g., laser 112 or another light source such as an SOA or light modulator) at the first displacement 124 at operation 504.

According to some examples, the method 500 includes forming further layers of the insulating dielectric material 104 to define a second displacement 126 at operation 506.

According to some examples, the method 500 includes forming a first dielectric waveguide 120 at the second displacement 126 at operation 508.

According to some examples, the method 500 includes forming further layers of the insulating dielectric material 104 to define a third displacement 128 at operation 510.

According to some examples, the method 500 includes forming second dielectric waveguide 122 at the third displacement 128, including an edge coupler 210, at block 512.

Although examples have been described as incorporating a laser light source, it will be appreciated that the devices, methods, and structures described herein are equally applicable to other light sources, including SOAs and optical modulators made from compound semiconductors (e.g., III-V materials) on silicon-on-insulator (SOI) substrates. In some examples, two dielectric waveguides (e.g., formed within silicon nitride layers of the device) are formed at a displacement or elevation similar to the compound semiconductor, or above it (i.e., further from the semiconductor substrate). The dielectric waveguides are adiabatically coupled to a silicon waveguide of the compound semiconductor light source and are used to expand the optical mode size at an edge of the device to achieve lower optical coupling losses to external optics.

Thus, in some examples, the light source includes a semiconductor optical amplifier. The first dielectric waveguide 120 and a portion of the semiconductor optical amplifier may be equally displaced from the semiconductor substrate with respect to the lamination axis.

In some examples, multiple dielectric waveguide layers may be used at the output edge coupler. Such a configuration may improve centering of the light mode in the dielectric stack.

In some examples, waveguides made in whole or in part from silicon or silicon compounds (e.g., Si₃N₄) may be used in the edge coupler.

Some examples described herein may achieve integration of high volume manufacturable laser with low-loss, large-MFD mode couplers. The laser remains in relatively close proximity to the substrate, assisting with heat sinking. Furthermore, there is no need for substrate removal at the edge coupler, which can give rise to reliability limitations.

Terms such as "above", "below", "upper", "lower", and other relative vertical positions are intended in this disclosure to refer to the relative positions of various features with respect to the lamination axis 132, along which layers of the device may be successively formed during fabrication. Similarly, terms such as "length" may refer to distances defined with respect to the longitudinal direction 130 (or opposite the longitudinal direction 130), and terms such as "lateral" or "width" may refer to distances or directions defined with respect to the lateral axis.

As will be appreciated, the processing operations described here may be carried out under computer control for the processing stages outlined with respect to Figure 12 above. Such computer control may rely upon program instructions executable to put such a control approach into practice. Such instructions may be provided to a processor of a control apparatus by way of a computer-readable medium. A computer readable medium may be provided by way of a computer-readable storage medium and/or a computer-readable transmission medium. A computer-readable storage medium, which may be referred to as a non-transitory computer-readable medium, stores instructions for use by a processor. Examples of a computer-readable storage medium may include a CD, a DVD, a storage device, a diskette, a tape, flash memory, physical memory, or any other computer-readable storage medium. As noted above, a computer-readable medium may also or alternatively be a transmission medium by which instructions may be conveyed. A computer-readable transmission medium may include carrier waves, transmission signals or the like. A computer-readable transmission medium may convey instructions between components of a single computer system and/or between plural separate computer systems.

Other examples of such an optical device may include features, and combinations or subcombinations of features, of the various examples described herein.

In view of the disclosure above, various examples are set forth below. It should be noted that one or more features of an example, taken in isolation or combination, should be considered within the disclosure of this application.

Therefore, from, one perspective, there has been describe a device that includes a semiconductor substrate, a light source displaced from the semiconductor substrate by a first displacement, a first dielectric waveguide displaced from the semiconductor substrate by a second displacement, and a second dielectric waveguide displaced from the semiconductor substrate by a third displacement. The second displacement is greater than the first displacement. The first dielectric waveguide overlaps at least a portion of the light source such that light is adiabatically coupled from the light source into the first dielectric waveguide. The third displacement is greater than the second displacement. The second dielectric waveguide overlaps at least a portion of the first dielectric waveguide such that light is coupled from the first dielectric waveguide into the second dielectric waveguide. The second dielectric waveguide includes an edge coupler configured to couple light out of the second dielectric waveguide.

The following are example embodiments:
Example 1 is a device comprising: a semiconductor substrate; a light source displaced from the semiconductor substrate by a first displacement with respect to a lamination axis; a first dielectric waveguide displaced from the semiconductor substrate by a second displacement with respect to the lamination axis, the second displacement being greater than the first displacement, the first dielectric waveguide overlapping at least a portion of the light source with respect to the lamination axis such that light is adiabatically coupled from the light source into the first dielectric waveguide; and a second dielectric waveguide displaced from the semiconductor substrate by a third displacement with respect to the lamination axis, the third displacement being greater than the second displacement, the second dielectric waveguide overlapping at least a portion of the first dielectric waveguide with respect to the lamination axis such that light is coupled from the first dielectric waveguide into the second dielectric waveguide; and the second dielectric waveguide comprising an edge coupler configured to couple light out of the second dielectric waveguide in a longitudinal direction perpendicular to the lamination axis.
In Example 2, the subject matter of Example 1 includes, wherein: the first dielectric waveguide has a first thickness defined with respect to the lamination axis; the second dielectric waveguide has a second thickness defined with respect to the lamination axis; and the first thickness is thicker than the second thickness.
In Example 3, the subject matter of Examples 1-2 includes, wherein: the edge coupler of the second dielectric waveguide comprises a plurality of segments, each segment decreasing in width as it extends in the longitudinal direction.
In Example 4, the subject matter of Examples 1-3 includes, wherein: the first dielectric waveguide comprises a plurality of segments, each segment increasing in width as it extends in the longitudinal direction.
In Example 5, the subject matter of Examples 1-4 includes, wherein: the first dielectric waveguide and the second dielectric waveguide each comprise silicon nitride.
In Example 6, the subject matter of Examples 1-5 includes, wherein: the third displacement is at least 1 micrometer greater than the second displacement.
In Example 7, the subject matter of Examples 1-6 includes, wherein: the third displacement is at least 3 micrometers.
In Example 8, the subject matter of Examples 1-7 includes, wherein: the light source comprises a hybrid silicon laser.
In Example 9, the subject matter of Example 8 includes, wherein: the hybrid silicon laser comprises: a III-V semiconductor structure; and a silicon waveguide displaced from the semiconductor substrate by the first displacement; and the first dielectric waveguide overlaps with a portion of the silicon waveguide with respect to the lamination axis.
In Example 10, the subject matter of Example 9 includes, wherein: the first dielectric waveguide and a portion of the III-V semiconductor structure are equally displaced from the semiconductor substrate with respect to the lamination axis.
In Example 11, the subject matter of Examples 1-10 includes, wherein: the light source comprises a semiconductor optical amplifier.
In Example 12, the subject matter of Example 11 includes, wherein: the first dielectric waveguide and a portion of the semiconductor optical amplifier are equally displaced from the semiconductor substrate with respect to the lamination axis.
In Example 13, the subject matter of Examples 1-12 includes, wherein: the device comprises a plurality of layers stacked with respect to the lamination axis.
In Example 14, the subject matter of Example 13 includes, wherein: the first displacement, second displacement, and third displacement each comprise one or more layers of an insulating dielectric material.
In Example 15, the subject matter of Examples 1-14 includes, a lens optically coupled to the edge coupler in the longitudinal direction to receive the light outcoupled by the edge coupler.
In Example 16, the subject matter of Example 1-15 includes, an optical fiber optically coupled to the edge coupler to receive the light from the edge coupler.
Example 17 is a device comprising: a semiconductor substrate; a hybrid silicon laser displaced from the semiconductor substrate by a first displacement with respect to a lamination axis; a first dielectric waveguide comprising silicon nitride and displaced from the semiconductor substrate by a second displacement with respect to the lamination axis, the second displacement being such that the first dielectric waveguide and the hybrid silicon laser at least partially overlap with respect to a longitudinal direction perpendicular to the lamination axis, the first dielectric waveguide overlapping at least a portion of the hybrid silicon laser with respect to the lamination axis such that light is adiabatically coupled from the hybrid silicon laser into the first dielectric waveguide; and a second dielectric waveguide comprising silicon nitride and displaced from the semiconductor substrate by a third displacement with respect to the lamination axis, the third displacement being greater than the second displacement by at least one micrometer, the second dielectric waveguide overlapping at least a portion of the first dielectric waveguide with respect to the lamination axis such that light is coupled from the first dielectric waveguide into the second dielectric waveguide; and the second dielectric waveguide comprising an edge coupler configured to couple light out of the second dielectric waveguide in the longitudinal direction.
In Example 18, the subject matter of Example 17 includes, wherein: the third displacement is at least 1 micrometer greater than the second displacement.
In Example 19, the subject matter of Examples 17-18 includes, wherein: the third displacement is at least 3 micrometers.
Example 20 is a method of manufacturing a device, the method comprising: forming one or more layers of an insulating dielectric material on a semiconductor substrate, the layers stacked with respect to a lamination axis, to define a first displacement from the semiconductor substrate; forming a light source at the first displacement; forming one or more further layers of the insulating dielectric material to define a second displacement from the semiconductor substrate; forming a first dielectric waveguide at the second displacement, the first dielectric waveguide overlapping at least a portion of the light source with respect to the lamination axis such that light is adiabatically coupled from the light source into the first dielectric waveguide; forming one or more further layers of the insulating dielectric material to define a third displacement from the semiconductor substrate; and forming a second dielectric waveguide at the third displacement, the second dielectric waveguide overlapping at least a portion of the first dielectric waveguide with respect to the lamination axis such that light is coupled from the first dielectric waveguide into the second dielectric waveguide; and the second dielectric waveguide comprising an edge coupler configured to couple light out of the second dielectric waveguide in a longitudinal direction perpendicular to the lamination axis.
Example 21 is at least one machine-readable medium including instructions that, when executed by processing circuitry, cause the processing circuitry to perform operations to implement of any of Examples 1-20.
Example 22 is an apparatus comprising means to implement of any of Examples 1-20.
Example 23 is a system to implement of any of Examples 1-20.
Example 24 is a method to implement of any of Examples 1-20.

## Claims

1. A device comprising:
a semiconductor substrate;
a light source displaced from the semiconductor substrate by a first displacement with respect to a lamination axis;
a first dielectric waveguide displaced from the semiconductor substrate by a second displacement with respect to the lamination axis, the second displacement being greater than the first displacement, the first dielectric waveguide overlapping at least a portion of the light source with respect to the lamination axis such that light is adiabatically coupled from the light source into the first dielectric waveguide; and
a second dielectric waveguide displaced from the semiconductor substrate by a third displacement with respect to the lamination axis, the third displacement being greater than the second displacement,
the second dielectric waveguide overlapping at least a portion of the first dielectric waveguide with respect to the lamination axis such that light is coupled from the first dielectric waveguide into the second dielectric waveguide; and
the second dielectric waveguide comprising an edge coupler configured to couple light out of the second dielectric waveguide in a longitudinal direction perpendicular to the lamination axis.

2. The device of claim 1, wherein:
the first dielectric waveguide has a first thickness defined with respect to the lamination axis; the second dielectric waveguide has a second thickness defined with respect to the lamination axis; and
the first thickness is thicker than the second thickness.

3. The device of claim 1 or 2, wherein:
the edge coupler of the second dielectric waveguide comprises a plurality of segments, each segment decreasing in width as it extends in the longitudinal direction.

4. The device of claim 1, 2 or 3, wherein:
the first dielectric waveguide comprises a plurality of segments, each segment increasing in width as it extends in the longitudinal direction.

5. The device of any preceding claim, wherein:
the first dielectric waveguide and the second dielectric waveguide each comprise silicon nitride.

6. The device of any preceding claim, wherein:
the third displacement is at least 1 micrometer greater than the second displacement.

7. The device of any preceding claim, wherein:
the third displacement is at least 3 micrometers.

8. The device of any preceding claim, wherein:
the light source comprises a hybrid silicon laser.

9. The device of claim 8, wherein:
the hybrid silicon laser comprises:
a III-V semiconductor structure; and
a silicon waveguide displaced from the semiconductor substrate by the first displacement; and
the first dielectric waveguide overlaps with a portion of the silicon waveguide with respect to the lamination axis.

10. The device of claim 9, wherein:
the first dielectric waveguide and a portion of the III-V semiconductor structure are equally displaced from the semiconductor substrate with respect to the lamination axis.

11. The device of any preceding claim, wherein:
the light source comprises a semiconductor optical amplifier; and
the first dielectric waveguide and a portion of the semiconductor optical amplifier are, for example, equally displaced from the semiconductor substrate with respect to the lamination axis.

12. The device of any preceding claim, wherein:
the device comprises a plurality of layers stacked with respect to the lamination axis; and
the first displacement, second displacement, and third displacement each comprise, for example, one or more layers of an insulating dielectric material.

13. The device of any preceding claim, further comprising:
an element optically coupled to the edge coupler, wherein the element comprises a lens optically coupled in the longitudinal direction to receive the light outcoupled by the edge coupler; and/or an optical fiber coupled to receive the light from the edge coupler.

14. The device of any preceding claim, wherein:
the second displacement is such that the first dielectric waveguide and the hybrid silicon laser at least partially overlap with respect to a longitudinal direction perpendicular to the lamination axis.

15. A method of manufacturing a device, the method comprising:
forming one or more layers of an insulating dielectric material on a semiconductor substrate, the layers stacked with respect to a lamination axis, to define a first displacement from the semiconductor substrate;
forming a light source at the first displacement;
forming one or more further layers of the insulating dielectric material to define a second displacement from the semiconductor substrate;
forming a first dielectric waveguide at the second displacement, the first dielectric waveguide overlapping at least a portion of the light source with respect to the lamination axis such that light is adiabatically coupled from the light source into the first dielectric waveguide;
forming one or more further layers of the insulating dielectric material to define a third displacement from the semiconductor substrate; and
forming a second dielectric waveguide at the third displacement,
the second dielectric waveguide overlapping at least a portion of the first dielectric waveguide with respect to the lamination axis such that light is coupled from the first dielectric waveguide into the second dielectric waveguide; and
the second dielectric waveguide comprising an edge coupler configured to couple light out of the second dielectric waveguide in a longitudinal direction perpendicular to the lamination axis.
